# EUROPEAN PATENT APPLICATION

(11) **EP 2 800 146 A1**
(43) Date of publication of application: **05.11.2014**
(21) Application number: 13166489.8
(22) Date of filing: 03.05.2013
(51) Int. Cl.: H01L 31/0224, H01L 31/18

(54) **Back contact substrate for a photovoltaic cell or module**

(71) Applicant: Saint-Gobain Glass France, 92400 Courbevoie (FR)
(72) Inventor: Palm, Jörg, 80797 Munich (DE); Auvray, Stephane, 92150 Suresnes (FR); Ruittenberg, Gerard, 52134 Herzogenrath (DE); Urien, Mathieu, 94120 Fontenay sous Bois (FR); Lechner, Robert, 81377 München (DE); Bon Saint Come, Yemina, 75004 Paris (FR); Singh, Laura Jane, 75011 Paris (FR)
(74) Representative: Neuviale, Bertrand

(57) **Abstract**

Back contact substrate (1) for a photovoltaic cell comprising a carrier substrate (2) and an electrode (6), the electrode (6) comprising an alloy thin film based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

## Description

The invention relates to the field of photovoltaic cells, more particularly to the field of non transparent back contact substrates used to manufacture thin film photovoltaic cells.

Specifically, in a known way, some thin film photovoltaic cells, referred to as second generation of photovoltaic devices, use a molybdenum-based back contact substrate coated with a thin light absorbing film (i.e., photoactive material), made of copper (Cu), indium (In), and selenium (Se) and/or sulphur (S) chalcopyrite. It can, for example, be a material of the CuInSe₂ type with a chalcopyrite structure. This type of material is known under the abbreviation CIS. It can also be CIGS, that is to say a material additionally incorporating gallium (Ga), or CIGSSe, that is to say a material incorporating both sulphur and selenium. A second class of materials is made of the Cu₂(Zn,Sn)(S,Se)₄ (i.e. CZTS) type with a Kesterite structure, using zinc and/or tin instead of indium and/or gallium. A third class is made of cadmium telluride (CdTe) and cadmium sulfide (CdS).

For the CIS, CIGS, CIGSSe and the CZTSSe types of applications, the back contact electrodes are generally based on molybdenum (Mo) because this material exhibits a number of advantages. It is a good electrical conductor (relatively low resistivity of the order of 10 µΩ2.cm). It can be subjected to the necessary high heat treatments since it has a high melting point (2610°C). It withstands, to a certain extent, selenium and sulphur. The deposition of the thin film of absorbing agent generally requires contact with an atmosphere comprising selenium or sulphur at a high temperature, which tends to damage the majority of metals. Molybdenum reacts with selenium or sulphur, in particular, forming MoSe₂, MoS₂ or Mo(S,Se)₂, but remains conductive and forms an appropriate ohmic contact with the CIS, CIGS, CIGSSe, CZTS or CdTe thin films. Finally, it is a material on which thin films of CIS, CIGS, CIGSSe, CZTS or CdTe types adhere well; the molybdenum even tends to promote the crystal growth thereof.

However, molybdenum exhibits a major disadvantage for industrial production: it is an expensive material. The cost of the raw material is high compared to aluminum or copper. Molybdenum thin films are normally deposited by magnetic-field-assisted cathode sputtering (i.e. magnetron sputtering). As a matter of fact, the manufacturing of molybdenum targets is expensive, too. This is all the more important as, in order to obtain the desired level of electrical conductance (a resistance per square of at most 2 Ω/□ and preferably at most 1 Ω/□, even preferably at most 0.5 Ω/□ after treatment in an atmosphere containing S or Se), a relatively thick thin film of Mo, generally of the order of from 400 nm to 1 micrometer, is necessary.

Patent Application WO-A-02/065554 by Saint-Gobain Glass France teaches the provision of a relatively thin film of molybdenum (less than 500 nm) and the provision of one or more thin films impermeable to alkali metals between the substrate and the molybdenum-based thin film, so as to retain the qualities of the molybdenum-based thin film during the subsequent heat treatments.

Nevertheless, this type of back contact substrate remains relatively expensive.

An object of the present invention is to provide a conductive and corrosion resistant back contact substrate, the manufacturing cost of which is relatively low.

To this end, an aspect of the present invention concerns in particular a back contact substrate for a photovoltaic cell comprising a carrier substrate and an electrode, the electrode comprising an alloy thin film based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

Such a back contact substrate exhibits the advantage of making it possible to obtain, with reduced cost materials, a resistance per square equivalent to that of a back contact substrate having an electrode made of molybdenum only, even after a heat treatment in a selenium atmosphere. Copper, silver and gold have significantly lower resistivity than molybdenum. Therefore only much thinner films are required to obtain the same sheet resistance compared to molybdenum. However, copper and silver have a very high affinity to sulphur and selenium, even at room temperature. The electrodes based on one or several first(s) element(s) chosen among copper (Cu), silver (Ag) and/or gold (Au) and on one or several second element(s) chosen among zinc (Zn), titanium (Ti), tin (Sn), silicon (Si), germanium (Ge), zirconium (Zr), hafnium (Hf), carbon (C) and lead (Pb) have a relatively good resistance to selenization, even at higher temperatures. It was rather surprising that for example the CuZn thin film resisted to selenization while a thin film of copper for example did not pass the test.

Although the use of silver seems to be contradictory to the goal of cost reduction, the cost of materials and coating will be lower than for molybdenum due to the much lower thickness of the thin film, which allows for a high throughput process and also due to the lower cost of manufacturing cost.

Gold however, is not a preferred material with respect to materials cost.

It is to be noted that the present invention may also be applied to CdTe and CdS type thin film solar cells, which also belong to the class of chalcogenide thin film solar cells, if these CdTe/CdS thin film solar cells are of the substrate type (as opposed to the superstrate type), that is to say if the manufacturing process starts with forming the back electrode on the substrate thus making a back contact substrate on which the absorber is formed. When forming the absorber, the back contact substrate is exposed to corrosive gases or liquids involving tellurium or sulphur as elements or in compounds.

According to specific embodiments, the back contact substrate comprises one or more of the following characteristics, taken separately or according to all the combinations technically possible:
- the alloy thin film is formed on the carrier substrate;
- said alloy thin film has a total atomic content of the first(s) element(s) M_{A} of at least 10%;
- said alloy thin film has a total atomic content of the second(s) element(s) M_{B} of at most 90%;
- said alloy thin film has a total atomic content of the first(s) element(s) M_{A} and of the second(s) element(s) M_{B} of at least 90%, preferably at least 95%;
- the first(s) element(s) M_{A} is/are chosen among copper (Cu) and silver (Ag);
- the second(s) elements(s) M_{B} is/are chosen among zinc (Zn), titanium (Ti) and tin (Sn);
- there is only one first element M_{A} or almost only one first element M_{A};
- there is only one second element M_{B} or almost only one first element M_{A};
- the alloy thin film is based on copper (Cu) and zinc (Zn), and said alloy thin film is preferably primarily in the α, β or ε crystallographic phase, preferably primarily in the β crystallographic phase;
- the alloy thin film is based on copper (Cu) and zinc (Zn), said alloy thin film preferably having a relative atomic content of Zn/(Cu+Zn) of at least 5% and at most 20%, or of at least 35% and at most 60%, or of at least 70% and at most 90%, more preferably of at least 35% and at most 60%;
- the alloy thin film is based on silver (Ag) and zinc (Zn), said alloy thin film preferably having a relative atomic content of Zn/(Ag+Zn) of at most 75% , preferably at most 50%, even more preferably at most 30%;
- the alloy thin film is based on copper (Cu) and titanium (Ti), said alloy thin film preferably having a relative atomic content of Ti/(Cu+Ti) of at most 10%, more preferably at most 5%;
- the alloy thin film is based on copper (Cu) and tin (Sn), said alloy thin film preferably having a relative atomic content of Sn/(Cu+Sn) of at most 30%;
- the alloy thin film is based on silver (Ag) and tin (Sn), said alloy thin film preferably having a relative atomic content of Sn/(Ag+Sn) of at most 20%, preferably at most 10%;
- the alloy thin film has at least two of the said first elements M_{A};
- the alloy thin film has at least two of the said second elements M_{B};
- at least two of the said second elements M_{B} are chosen among zinc (Zn), tin (Sn) and titanium (Ti);
- two of the said second elements M_{B} are zinc (Zn) and titanium (Ti);
- two of the said second elements M_{B} are zinc (Zn) and tin (Sn);
- the first(s) element(s) is/are chosen among copper (Cu) and silver (Ag);
- the alloy thin film is based on copper (Cu), zinc (Zn) and tin (Sn);
- the alloy thin film is based on copper (Cu), zinc (Zn) and titanium (Ti), said alloy thin film preferably having a relative atomic content of Zn/(Cu+Zn) of at least 20% and at most 60%;
- the alloy thin film is based on copper (Cu), zinc (Zn) and titanium (Ti), said alloy thin film preferably having a relative atomic content of titanium (Ti)/(Cu+Zn+Ti) of at most 30% and at least 1%, preferably at most 20% and at least 5%;
- said alloy thin film further contains one or more among the following additional elements: aluminum (Al), platinum (Pt), molybdenum (Mo), manganese (Mn), vanadium (V), antimony (Sb), arsenic (As) with a total maximum atomic content of at most 5%;
- said alloy thin film further contains oxygen (O) and/or nitrogen (N) with a total maximum atomic content of at most 5%;
- said alloy thin film has a resistivity of at most 15 µΩ.cm, preferably of at most 10 µΩ.cm;
- said alloy thin film has a thickness between 20nm and 300nm, preferably between 40nm and 150nm;
- said alloy thin film has a sheet resistance below 2 Ω/□, preferably below 1 Ω/□;
- said electrode (6) further comprises an adhesion thin film between the carrier substrate and the alloy thin film;
- said adhesion thin film is based on at least one of titanium (Ti), palladium (Pd), nickel (Ni) and chromium (Cr);
- said electrode (6) further comprises a barrier to selenization thin film (10) for protecting the alloy thin film from selenization;
- the barrier to selenization thin film is formed on the alloy thin film;
- the electrode comprises a barrier to selenization thin film for protecting the alloy thin film and based on at least one among MoₓO_{y}N_{z}, WₓO_{y}N_{z}, TaₓO_{y}N_{z}, NbₓO_{y}N_{z}, ReₓO_{y}N_{z};
- the barrier to selenization thin film has a compressive stress between 0 and -10GPa, preferably between -1 and -5 GPa;
- the barrier to selenization thin film is nano-crystalline or amorphous with a grain size of at most 10nm;
- the barrier to selenization thin film has a molar composition O/(O+N) of at least 1 % and at most 50%;
- the barrier to selenization thin film has a molar composition M'/(M'+O+N) of at least 15% and at most 80%;
- the barrier to selenization thin film has a thickness of at least 5 nm and at most 100nm, preferably at least 10nm and at most 60nm;
- said electrode (6) further comprises an interlayer thin film formed on the alloy thin film or between the alloy thin film and the barrier to selenization thin film if present, the interlayer thin film being based on at least one of titanium (Ti), tungsten (W), molybdenum (Mo), rhenium (Re), niobium (Nb) or tantalum (Ta);
- said electrode (6) further comprises an ohmic contact thin film based on at least a metal M;
- the ohmic contact thin film is formed on the alloy thin film and on the barrier to selenization thin film if present;
- the ohmic contact thin film is to be in contact with the photoactive thin film;
- said metal M is capable of forming a compound of semiconducting sulphide and/or selenide of p type capable of forming an ohmic contact with the photoactive semiconducting material;
- said ohmic contact thin film is based on molybdenum (Mo) and/or tungsten(W);
- the back contact substrate further comprises a barrier to alkali thin film between the carrier substrate (2) and the electrode (6);
- the barrier thin film is formed on the carrier substrate;
- the barrier to alkali thin film is based on at least one of: silicon nitride, silicon oxide, silicon oxynitride, silicon oxycarbide, aluminum oxide and aluminum oxynitrure;

The alloy thin film may be produced by depositing several metallic layers of different materials followed by a thermal annealing treatment which can be the heat treatment used for making the absorber thin film.

The intermediate product thus has different metallic thin films which will later form the alloy thin film. Thus, according to another aspect, the invention concerns a back contact substrate for a photovoltaic cell comprising a carrier substrate and an electrode, the electrode comprising an electrically conductive coating comprising adjacent metallic thin films, at least one of the adjacent metallic thin films being based on at least a first element chosen among copper (Cu), silver (Ag) and gold (Au), and at least one of the adjacent metallic thin films being based on a at least a second element chosen among zinc (Zn), titanium (Ti), tin (Sn), silicon (Si), germanium (Ge), zirconium (Zr), hafnium (Hf), carbon (C) and lead (Pb).

According to specific embodiments, the back contact substrate comprises one or more of the following characteristics, taken separately or according to all the combinations technically possible:
- at least one of the metallic thin films is made of an alloy;
- at least one of the metallic thin films is based on a single chemical element;
- each of the metallic thin films is based on a single chemical element;
- after a thermal annealing treatment, the back contact substrate is as described above.

Another subject- matter of the invention is a photovoltaic cell comprising a back contact substrate as described above and at least a thin film of a photoactive material.

According to a specific embodiment, said photoactive material is based on chalcogenide compound semiconductors for example a material of Cu(In,Ga)(S,Se)₂ type, in particular CIS,CIGS, CIGSSe or also a material of Cu₂(Zn,Sn)(S,Se)₄ type.

Another subject- matter of the invention is a photovoltaic module comprising several photovoltaic cells formed on the same carrier substrate and electrically connected in series, each photovoltaic cell being as described above.

Another subject- matter of the invention is a process for the manufacture of a back contact substrate for a photovoltaic cell, comprising at least one step of making an alloy thin film based on at least two elements, at least one first element M_{A} chosen among copper (Cu), silver (Ag) and gold (Au), and a at least one second element M_{B} chosen zinc (Zn), titanium (Ti), tin (Sn), silicon (Si), germanium (Ge), zirconium (Zr), hafnium (Hf), carbon (C) and lead (Pb)

According to specific embodiments, the process exhibits one or more of the following characteristics, taken separately or according to all the combinations technically possible:
- the step of making the said alloy thin film (8) comprises:
   ● forming a thin film containing at least one of the first element(s) M_{A}; and
   ● forming another thin film of a different material and containing at least one of the second element(s) M_{B}.
- the material of at least one of said thin films is based on only one element.
- the material of at least one of said thin films is an alloy.
- the step of making the said alloy thin film comprises a step of depositing an alloy thin film based on at least one first element M_{A} and at least onesecond element M_{B}.
- there is a gradient of at least some of the elements of said alloy thin film inside said alloy thin film.
- the process comprises a thermal annealing step during which resistivity of the electrode is decreased, and the obtained sheet resistance after thermal annealing is below 2 Ω/□, preferably below 1 Ω/□.

Another subject- matter of the invention is a process for the manufacture of a photovoltaic cell on a back contact substrate as described above, comprising a step of formation of a photoactive thin film during which resistivity of the electrode is decreased, and the obtained sheet resistance after thermal annealing is below 2 Ω/□, preferably below 1 Ω/□.

According to a specific embodiment, during said step of formation of a photoactive thin film, said ohmic contact thin film based a metal M is transformed into a sulphide and/or selenide of said metal M.

A better understanding of the invention will be obtained on reading the description which will follow, given solely by way of example and made with reference to the appended drawings, in which:
- Figure 1 is a diagrammatic view in cross section of a back contact substrate;
- Figure 2A is a phase diagram of copper (Cu) and zinc (Zn);
- Figure 2B is a plot showing resistivity of a CuₓZn_{y} thin film for different CuZn compositions and processes;
- Figure 3 are photographs of different back electrodes after a selenization test;
- Figure 4 shows micrographs of the samples corresponding to Figure 3;
- Figure 5 is a plot showing resistivity of a CuZnTi thin film for different compositions;
- Figure 6A is a silver (Ag) - zinc (Zn) phase diagram;
- Figure 6B is a plot showing resistivity of a AgₓZn_{y} thin film for different AgZn compositions;
- Figure 6C is a copper (Cu) - titanium (Ti) phase diagram;
- Figure 6D is a plot showing resistivity of a CuₓTi_{y} thin film for different CuTi compositions;
- Figure 6E is a copper (Cu) - tin (Sn) phase diagram;
- Figure 6F is a silver (Ag) - tin (Sn) phase diagram;
- Figure 7 is a plot showing a measured mass gain after selenization for different selenization barrier thicknesses and different CuₓZn_{y} thin film compositions;
- Figure 8 is a diagrammatic view in cross section of a solar cell stack;
- Figure 9 are photographs analogous to Figure 3 for back electrodes having respectively from left to right, an interlayer of titanium between the CuZn thin film and the MoN barrier to selenization thin film, an interlayer of molybdenum, and no interlayer;
- Figure 10 is a SIMS elemental profile of a back electrode having a titanium interlayer;
- Figures 11A and 11B are respectively a titanium (Ti) and zinc (Zn) phase diagram and a copper (Cu) and titanium (Ti) phase diagram;
- Figure 12 shows optical micrographs as seen through the glass of P1 patterned stacks before and after an RTP process.
- Figure 13 shows photographs of the glass side and thin film side of a solar cell using a CuZn back electrode.

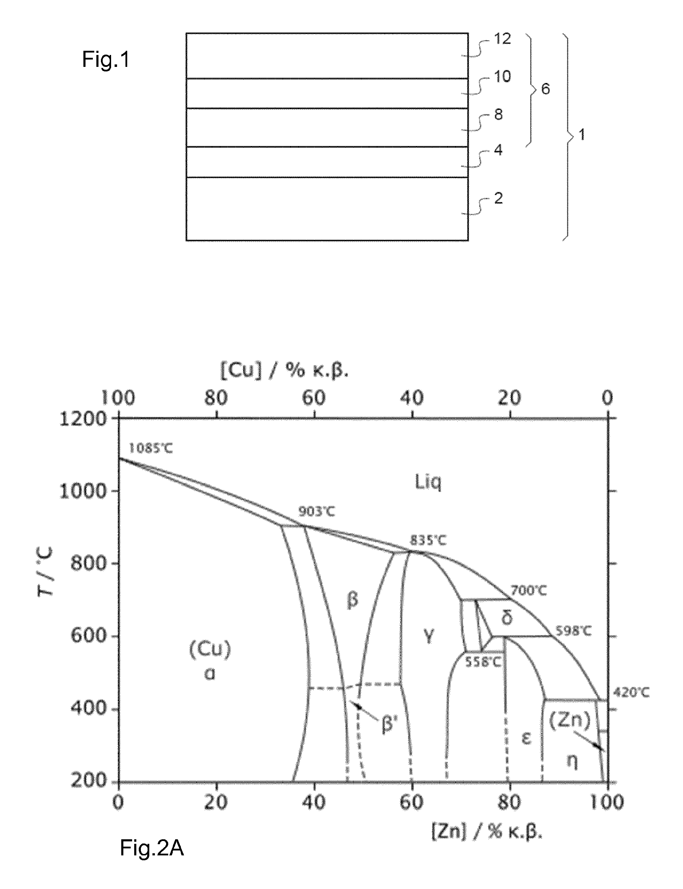

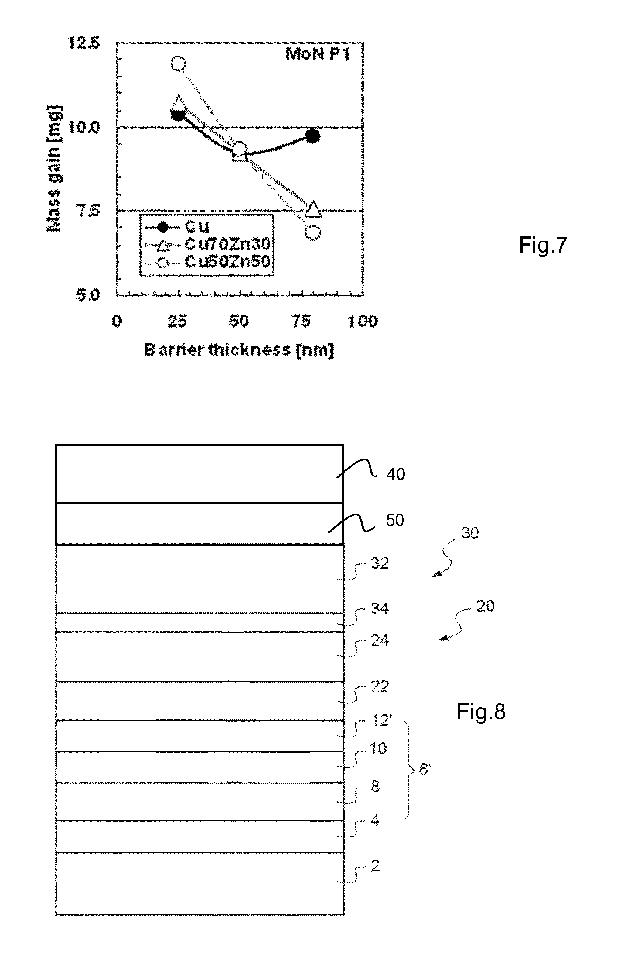

The drawings in Figures 1 and 8 are not to scale, for a clear representation, as the differences in thickness between in particular the carrier substrate and the thin films deposited are significant, for example of the order of a factor of 5000.

Figure 1 illustrates a back contact substrate 1 for a photovoltaic cell comprising:
- a carrier substrate 2, for example made of glass;
- a barrier to alkali thin film 4 formed on the substrate 2; and
- an electrode 6 formed on the barrier to alkali thin film 4.

Throughout the text, the expression "A formed (or deposited) on B" is understood to mean A is formed either directly on B and thus in contact with B or formed on B with interposition of one or more thin films between A and B.

It should be noted that, throughout the text, the term "electrode" is understood to mean an electrical current transport coating comprising at least one thin film which conducts electrons, that is to say having a conductivity which is provided by the mobility of electrons.

It should also be noted that, throughout the text, it is hereby meant by "a material based on A" that the material is mainly made of A, so that its aimed function is fulfilled. It preferably contains at least 80% atomic percent of A, for example at least 90% atomic percent of A. If the material is "based on A and B", it is meant that it preferably contains at least 80% total atomic percent of A and B, for example at least 90% total atomic percent of A and B.

It is meant by "total atomic content" that the atomic contents of the elements are added. If the atomic content of A is 35% and the atomic content of B is 55%, the total atomic content of A and B is 90%.

In addition, throughout the text, the expression "comprises a thin film" should, of course, be understood as "comprises at least one thin film".

The barrier to alkali thin film 4 is, for example, based on one of: silicon nitride, silicon oxide, silicon oxynitride, silicon oxycarbide, aluminum oxide or aluminum oxynitride, as will be further explained below.

The electrode 6 illustrated is composed of:
- an alloy thin film 8 formed directly on the barrier to alkali thin film 4;
- a barrier to selenization thin film 10, formed directly on the alloy thin film 8; and
- an ohmic contact thin film 12 based on a metal M and formed directly on the barrier to selenization thin film 10.

The alloy thin film 8 forms a main conductive coating of the electrode. It is essential for achieving the required conductance of the electrode 6 and will be further explained in detail below. The main conductive coating may comprise only the alloy thin film or several thin films including the alloy thin film.

It should be noted that, throughout the text, the term "only one thin film" is understood to mean a thin film of one and the same material. This single thin film can nevertheless be obtained by the superposition of several thin films of one and the same material, between which exists an interface which it is possible to characterize, as described in WO-A-2009/080931.

As will be further explained below, the alloy thin film 8 is based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

The barrier to selenization thin film 10 protects the alloy thin film 8 from selenization. It is, for example, a thin film of a metal nitride or oxynitride such as TiOₓN_{y}, MoOₓN_{y}, ZrOₓN_{y}, TaOₓN_{y}, AlOₓN_{y} or of a metal oxide such as MoOₓ or TiOₓ.

The ohmic contact thin film 12 is for establishing a good electrical contact with the light absorbing chalogenide thin film to be deposited directly above. It is for example based on molybdenum or tungsten, before selenization.

The barrier to selenization thin film 10 and the ohmic contact thin film 12 will be further explained below.

Such a back contact substrate 1 is intended for the manufacture of a photoactive material with addition of sodium. This element is known to improve the performance of photoactive materials of CIS, CIGS or CIGSSe type. As the sodium content is a key parameter in the process, the sodium migration from the glass towards the photoactive material needs to be controlled and so, the presence of an alkali barrier film 4 can be needed. In the case where the substrate does not comprise alkali species or as impurity, the barrier to alkali thin film 4 can be omitted. By "alkali", it is meant "alkali element" whatever its oxidation state, i.e. in metallic or ionic form. A typical glass substrate is for example, a soda-lime-silica glass and comprises sodium ions.

Another technique for the manufacture of the photoactive material consists in using the migration of the sodium ions from the carrier substrate, for example made of glass, in order to form the photoactive material. In this case, the back contact substrate 1 does not have a barrier to alkali thin film 4 and the alloy thin film 8 is, for example, formed directly on the carrier substrate 2.

In an alternative form also, the electrode 6 comprises one or more inserted thin films.

Thus, generally, the back contact substrate 1 comprises a carrier substrate 2 and an electrode 6 comprising:
- an alloy thin film 8 formed on the carrier substrate 2, the alloy thin film 8 being based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb);
- a barrier to selenization 10 formed on the alloy thin film 8; and
- an ohmic contact thin film 12 based on a metal M and formed on the barrier to selenization thin film 10.

For CIS, CIGS and CIGSSe, having an ohmic contact thin film 12 for example based on molybdenum is preferred, but other chalcogenide semiconductors like AgInS₂ , CZTS or CdTe may function well if deposited directly on the alloy thin film 8. Thus, in an alternative form, the electrode 6 does not comprise the barrier to selenization and the ohmic contact thin film.

In another alternative form also, the electrode comprises the barrier to selenization without the ohmic contact thin film. In this case, the barrier to selenization thin film 10 needs to form a good ohmic contact to the light absorbing thin chalogenide film.

In another alternative form also, the electrode comprises the ohmic contact thin film formed directly on the alloy thin film 8 without a barrier to selenization. This configuration can be sufficient if the process of forming the chalcogenide absorber thin film is at lower temperatures or with lower partial pressure of sulfur, selenium or tellurium. Usually processes on plastic foils for example, require much lower processing temperatures. Even though the examples given below use high temperature selenization processes, there exists lower temperature selenization processes such as the co-evaporation process, which induce less corrosion and do not necessarily require additional protection of the alloy thin film against selenization, given the newly found high resistance of the above alloy thin film.

Thus, even more generally, the back contact substrate 1 comprises a carrier substrate 2 and an electrode 6 comprising an alloy thin film 8 formed on the carrier substrate 2, the alloy thin film 8 being based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

The electrode coating 6 may further comprise an adhesion thin film (not represented) formed on the carrier substrate 2, between the alloy thin film 8 and the carrier substrate 2, more precisely, between the alloy thin film 8 and the barrier to alkali thin film 4 if present. Preferably, the alloy thin film 8 is formed directly on the adhesion thin film.

The adhesion thin film is preferably based on one among titanium (Ti), palladium (Pd), nickel (Ni), and chromium (Cr).

In another embodiment, the electrode coating 6 may also comprise an interlayer thin film (not represented), between the alloy thin film 8 and the barrier to selenization thin film 10 if present. The interlayer thin film is preferably formed directly on the alloy thin film 8. The interlayer thin film is preferably based on molybdenum (Mo), titanium (Ti), tantalum (Ta), rhenium (Re), niobium (Nb) or tungsten(W). This will be further explained below.

### Alloy thin film

The characteristics, properties and experiments concerning the alloy thin film 8 will now be described in more detail.

It should first be noted that the term "alloy" is meant to mean a mixture of either pure or fairly pure chemical elements (at least one of which being a metal) which forms an impure substance (admixture) that retains the characteristics of a metal. An alloy may not necessarily be a perfectly uniform mix of the atoms of the elements or be perfectly pure. It may be formed, for example, by depositing a thin film of a first element or alloy, subsequent depositing of a thin film of a second element or alloy, followed by a thermal annealing step making an alloy of the first and second elements or alloys. The sequence element/alloy or element₁/element₂, or alloy₁/alloy₂ can be repeated several times (element/alloy/element/alloy.....)

But, after a thermal annealing treatment or before, the alloy thin film is based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

There may be one or several first elements M_{A} and one or several second elements M_{B}.

The alloy thin film may for example be based on:
- only one first element M_{A} and only one second element M_{B} (e.g. CuZn),
- only one first element M_{A} and several second elements M_{B} (e.g. CuZnTi),
- on several first elements M_{A} and only one second element M_{B} (e.g. CuAgZn),
- or several first elements M_{A} and several second elements M_{B} (e.g. CuAgZnTi),

An advantage of such an alloy is its lower resistivity compared to molybdenum, its lower cost and its capability to maintain or reduce its resistivity during the solar cell process in the presence of heat and corrosive elements such as sulphur, selenium or tellurium. The product of resistivity * density is also much lower.

The function of the alloy thin film 8 is conducting the electrical current of the solar cell. A key requirement is its corrosion resistance to sulfur and selenium. Depending on the process, the alloy thin film may need to withstand temperatures up to 600°C. Table I shows the properties of the preferred elements.

**Table I Melting point, conductivity and density for each preferred material. [**

| | melting point | Conductivity | density | Periodic Group |
|---|---|---|---|---|
| Titanium (Ti) | 1668°C | 2.5 · 10⁶A/(V · m) | 4.5 g/cm³ | M(IVb) |
| Zirkonium (Zr) | 1857 ° C | 2.36 · 10⁶ A/(V · m | 6.5 g/cm³ | M(IVb) |
| Tin (Sn) | 231.9 ° C | 8.69 · 10⁶ A/(V · m) | 5.77 g/cm³ (α-Zinn) 7.26 g/cm³ (B-Zinn) | M(IVa) |
| Zinc (Zn) | 419.5 °C | 16,6×10⁶ A/(V · m) | 7.14 g/cm³ | M(IIb) |
| Copper (Cu) | 1084.6°C | 59.1 · 10⁶ A/(V · m | 8.92 g/cm³ | M(Ib) |
| Silver (Ag) | 961.8°C | 61.4 · 10⁶ A/(V m)· | 10.49 g/cm³ | M(Ib) |

Copper (Cu) and silver (Ag) are preferred for the first(s) element(s)M_{A}.

Zinc (Zn), titanium (Ti), tin (Sn) and Zirconium (Zr) are preferred for the second(s) element(s) M_{B}.

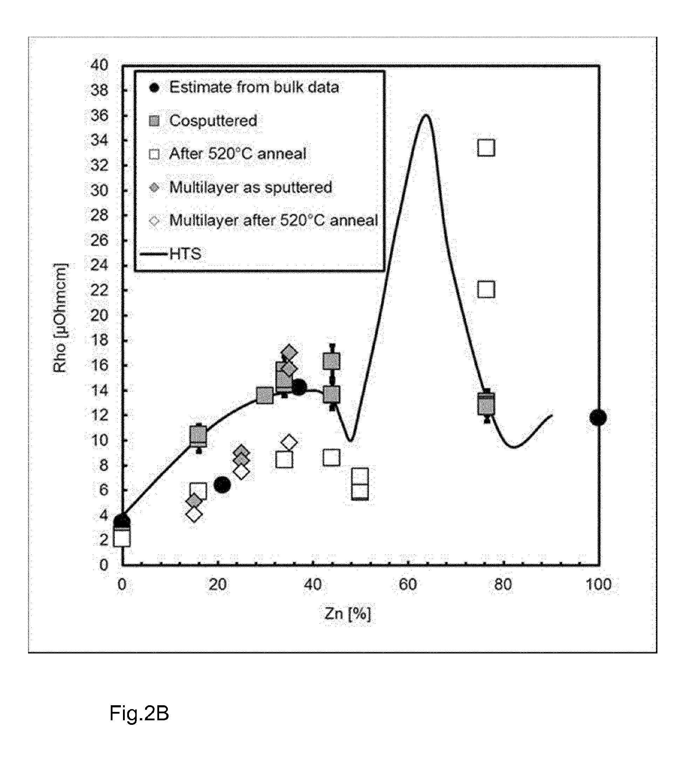

The resistivity of M_{A} and M_{B} alloys also depends significantly on the M_{B} atomic content in the alloy and on the prevailing alloy phase or composition of alloy phases, as shown on Fig. 2A and Fig.2B for Cu-Zn.

Fig. 2B shows the measured resistivity of CuZn thin films vs. the atomic Zn content. For this data 100nm of CuZn were deposited by magnetron sputtering at room temperature. In the case of grey filled squares, labeled "cosputtered", the thin films were sputtered in about 50 passes under a Cu target and a Zn target in a rotating substrate holder. Grey filled diamonds, labeled "multilayer as sputtered", were deposited in four passes Cu/Zn/Cu/Zn. The data labeled HTS (that stands for HighTroughPut) was obtained from small samples deposited under a Cu target and a Zn target that were arranged so to obtain a continuous gradient of the Cu/Zn ratio. Open squares represent the resistivity of (quasi)-cosputtered thin films after thermal annealing at 520°C during 3 minutes. Open diamonds represent the resistivity of a multilayer stack after thermal annealing at 520°C during 3 minutes. The black filled circles are obtained by scaling published data from bulk brass by a constant factor which accounts for the generally observed increase of resistivity comparing thin films and bulk materials. The resistivity of the as-deposited thin films was usually found to have decreased after thermal annealing, the resistivity was the lowest for pure Cu, increased with increasing Zn content and showed a distinct minimum at about 50% Zn atomic content. This region corresponds to the beta phase as shown in diagram of Fig.2A. For higher Zn contents, the resistivity showed a more complex behavior. But the data HTS indicated a second minimum around 80% which corresponds to the epsilon phase.

In order to have a good solar cell efficiency, the alloy thin film 8 needs to be of a sufficient thickness for the electrode 6 and the alloy thin film 8 to have, after a selenization test as described above, a resistance per square of at most 2 Ω/□, preferably of at most 1 Ω/□ or best at most 0.5 Ω/□.

In order to reduce the materials cost of the back contact substrate, the alloy thin film 8 preferably has a thickness between 20nm and 300nm, more preferably between 30nm and 150nm.

For an optimized efficiency at a low cost, the resistivity of the alloy thin film 8 should therefore preferably not exceed 15 µΩ.cm, preferably less than 10 µΩ.cm. From the sputtering experiments shown in Fig.2B, significant dependencies of the resistivity on the Zn atomic content have been observed. Several regions for compositions of the Cu-Zn alloy are preferred:
- the alpha phase (Zn atomic content between 5% and 20%);
- the beta phase (Zn atomic content between 35% and 55%);
- the epsilon phase (Zn atomic content between 70% and 90%).

However, the Zn atomic content does not need to be limited to the above compositions and more generally, the Zn atomic content is between 5% and 90%. And preferably, in the case of a CuZn alloy, the alloy thin film 8 has a Zn atomic content between 5 and 20%, or between 35 and 55%, or between 70 and 90%.

Concerning the chemical properties, the alloy composition and thus phase needs to be carefully chosen to achieve selenization resistance.

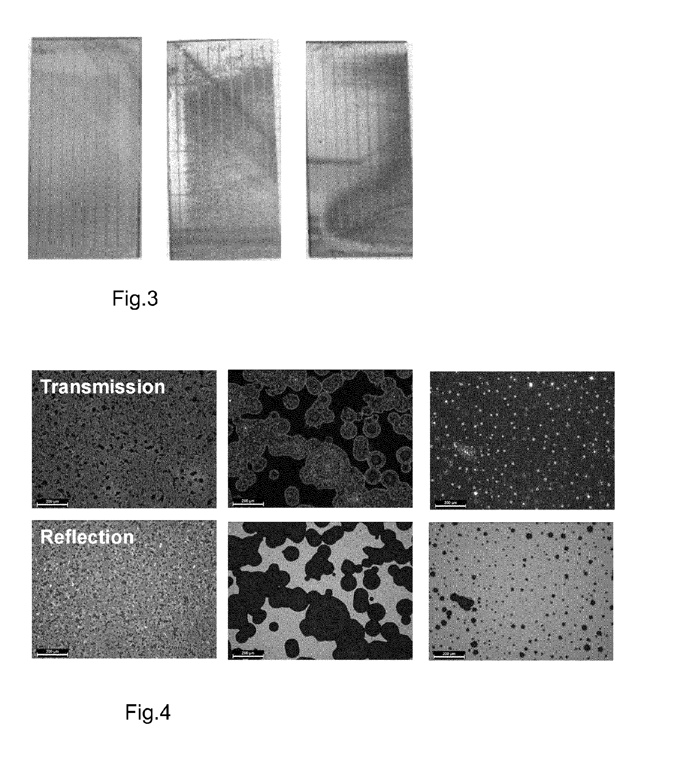

The example illustrated on Fig.3 proves that the corrosion indeed is strongly reduced for CuZn-based thin films in comparison with pure Cu-based thin films. In the experiment, a 200nm CuZn thin film was deposited on a glass coated with a Si₃N₄ alkali barrier with three different compositions: Cu only (left), Cu70Zn30 (center) and Cu50Zn50 (right), in atomic percentage. An 80nm thick MoN-thin film was deposited on the alloy thin film as a selenization barrier and thin films of 35nm Mo were deposited on top of the Cu or CuZn thin films. The selenization behavior was then tested at 520°C for 10 minutes in a selenium atmosphere. The pictures of Fig.3 show the appearance of the thin films from the glass side (size 5×10cm²) after the selenization test: the Cu thin film (left) is strongly corroded, the initial Cu color has turned into grey. The Cu70Zn30 and the Cu50Zn50 still show the gold color of the brass thin film with some grey shades.

The amount of selenization can be measured by calculating the weight difference before and after the selenization test. The mass difference is caused by the binding of selenium to metal thus forming metal selenides. A higher weight gain shows a stronger selenization. The degree of selenization can also be determined by measuring the sheet resistance before and after the selenization. Both parameters, weight gain and sheet resistance changes, are depicted in the following table for different CuZn compositions:

**Table II: Mass gain and resistivity were measured for the three samples illustrated on Fig.3 respectively from left to right**

| | Cu | CU₇₀Zn₃₀ | CU₅₀Zn₅₀ |
|---|---|---|---|
| **Mass gain [mg] (5×10cm²)** | **8,8** | **7,4** | **6,2** |
| **Sheet resistance [Ω**_{□}**]** | **50** | **2** | **4** |

Zn improves resistance to selenization, as shown by the reduced mass gain with higher Zn content. The second sample with a Zn content of 30% showed better resistivity, implying that the resistance to selenization was also improved compared to pure copper.

Fig.4 are micrographs of the same samples. As shown on Fig.4, alloying with Zn may also lead to a binding of Cu which could reduce the risk of Cu diffusion through the barrier into the absorber thin film. The degree of binding the Cu in the alloy seems to increase with increasing Zn content. In the optical micrographs shown in Figure 4, the corrosion induced to the CuZn thin films during the selenization is illustrated. The top row of images shows the thin films after selenization in transmission, the bottom row in reflection. The thin film stack with pure Cu is almost completely translucent with a reddish color. The metal thin film has transformed into Cu selenides. By alloying with Zn, the opaque areas grow in size and fraction. In this example, Cu₅₀Zn₅₀ shows only small spots of corrosion. These results show the surprising capability of CuZn to withstand a selenization at high temperatures, whereas a pure copper film is totally corroded despite a protecting MoN thin film. The affinity of Cu to selenium is so high that even 50nm of MoN cannot avoid corrosion. After alloying with Zn, corrosion is strongly reduced.

Also, apart from the Zn rich side, the melting point of CuZnₓ is significantly higher than 700°C, which is advantageous for the chalcogenide absorber processing. The melting point decreases with Zn atomic content (see phase diagram on Figure 2A). The attractive region of temperature above 700°C extends up to 80% of Zn atomic content. If the thermal process window below 600-650°C is still tolerable, also the full epsilon phase region (Zn atomic content of 80-90%) is available as the alloy thin film material. The best corrosion resistance, however, was found to be in the range of the beta phase. At last, the cost of an alloy of copper - zinc is not much higher than the cost of copper alone.

The composition region of the CuZn beta phase (Zn-content between 35% and 55%) turned out to be very advantageous as the resistivity has a minimum in this range and, as shown above, the corrosion resistance was at its maximum.

Here, the coincidence of the predominant alloy phase with the net elemental composition as expected from the phase diagram is not straightforward. Via XRD characterization, the transformation of phases during thermal annealing towards those expected from the phase diagram could be shown, while in the as-sputtered films, depending of the sputtering conditions, the coexistence of non-equilibrium phases was detected.

As observed in experiments of the inventors, adding a thin layer of Ti to a CuZn stack results in a CuZnTi alloy after thermal annealing during the solar cell process. First results show excellent solar cell efficiencies and excellent properties for laser patterning. Ti forms a very stable oxide. Titanium metal is therefore very corrosion resistant due to a self-protecting TiO₂ surface layer.

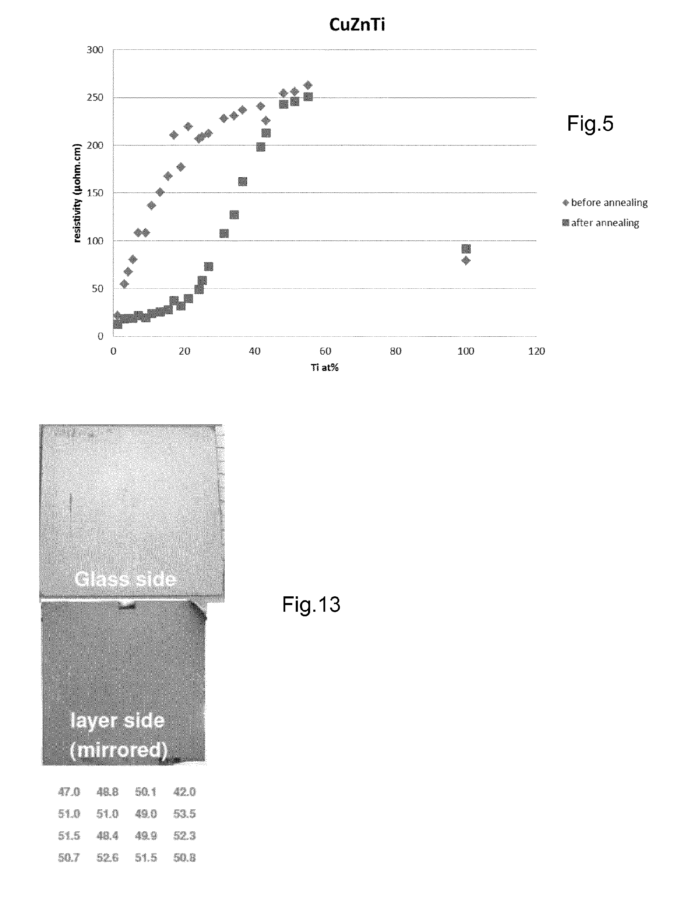

Fig.5 shows the measured resistivity of CuZnTi thin films vs. the atomic Ti content. The atomic content of Zn/(Zn+Cu) was chosen so that it be in the alpha phase of the CuZn alloy (with a set point of 30% relative atomic percent of Zn/Zn+Cu). For this data, 80nm of CuZnTi were deposited by magnetron sputtering at room temperature, by co-sputtering of a Cu target, a Zn target and a Ti target. The diamonds correspond to the measured resistivity before annealing and the squares to the measured resistivity after annealing at 550°C during 3 minutes.

It was found that adding a small amount of Ti has a significant impact on the resistivity of the alloy.

For obtaining a resistivity below 20µΩ.cm, an atomic content of titanium of at most 10% is preferred, more preferably at most 5%.

The corrosion resistance effect is often attributed to the formation of a protective oxide film at the surface due to the affinity of Ti to oxygen. Other elements of group IVa and IVb, such as Sn, Ge, Si, Zr and Hf also form such stable oxides. This mechanism should not take place when the film is protected by a selenization barrier and the corrosion by sulphur happens in a very low oxygen atmosphere which is typical for the formation of chalcogen solar cell. Nevertheless the formation of a thin oxide protective film can be useful for thin film solar modules: The CuTi self-protection effect can take place during the P1 patterning step. In this step, the electrode is cut into cells leaving 10-100µm wide trenches. The patterning processes usually are laser processes. In case of an electrode stack with a metal layer and diffusion barrier, the P1 trench will expose an unprotected edge of the metal alloy. At this edge the thin film can oxidize and it has a better protection against corrosion during the subsequent absorber formation process because the group IV oxide film that forms at the edges is more stable than the corresponding sulphides. The upper limit for the content of Ti will be mostly likely given by the resistivity.

This is why, even though most experiments were so far directed to CuZn, and CuZnTi, AgZn, and CuTi, alloys such as, for example, CuSn, AgSn, CuAgSn, CuZnSn, ,etc. are suitable.

Non limiting lists of possible alloys are as follows:
● MAZn, MATi, MASn, MASi, MAGe, MAZr, MAHf, MAC, MAPb with MA being Cu, Ag, Au, CuAg, CuAu, AgAu or CuAgAu;
● CuMB, AgMB, AuMB, CuAgMB, CuAuMB, AgAuMB or CuAgAuMB with MB being Zn, Ti, Sn, Si, Ge, Zr, Hf, C, Pb, ZnTi, ZnSn, ZnSi, ZnGe, ZnZr, ZnHf, ZnC, ZnPb, ZnTiSn, ZnTiSi, or any other possible combination of MB elements.

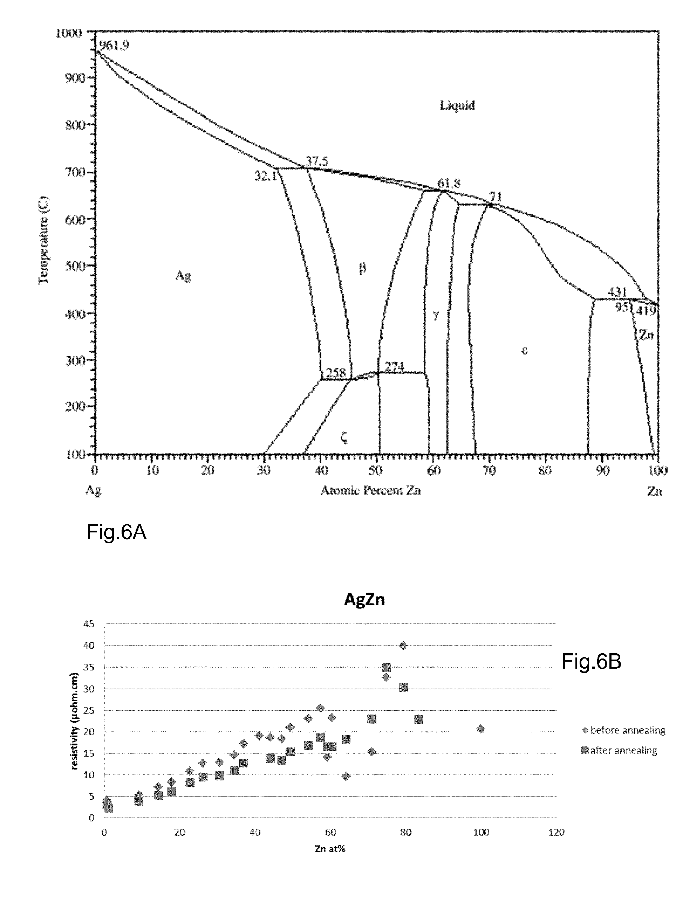

As shown in Fig. 6A, the phase diagram of Ag-Zn is very similar to that of Cu-Zn. The melting points are lower. Ag has a slightly higher conductivity than Cu. The corrosion resistance of pure Ag is higher than that of pure Cu. The improvement by adding Zn is explained by the similarity between the AgZn system and the CuZn system. The addition of Zn will decrease conductivity though, but also the materials costs.

Fig. 6B shows the measured resistivity of AgZn films vs. the atomic Zn content. For this data, 100nm of AgZn were deposited by magnetron sputtering at room temperature, by co-sputtering of a Ag target and a Zn target. The diamonds correspond to the measured resistivity before annealing and the squares to the measured resistivity after annealing at 550°C during 3minutes.

A preferred resistivity after annealing is below 20 µΩ.cm. From these results, it thus appears that an atomic content of zinc of at most 75% is preferred in terms of resistivity, more preferably at most 40%, even more preferably at most 30%.

From the phase diagram, it appears that the beta phase should also be a good compromise between resistivity, corrosion resistance and cost. But the alpha range is also interesting since the results in Fig.6B show that the resistivity increases slowly with Zn content.

Although the high materials cost of Ag appear to be in contradiction with the aim of having a low cost large area back electrode for thin film solar modules, the relatively low resistivity of AgZn that was found, brings Ag back into the range of interesting back electrode materials. At a resistivity of 10 µΩ.cm or below, an AgZn thin film of only 155 nm is required to obtain a sheet resistance of 0.65 Ω/□.

Also, addition of Cu (i.e. Ag-Cu-Zn) is beneficial to the hardness of the alloy. With increasing Cu content, the melting point is strongly reduced and at 40at% the phase Ag-Cu diagram shows an eutectic point, i.e the alloy becomes liquid already at 800°C. The maximum solubility is around 15%. Cu reduces the corrosion resistance of silver. A pure Ag-Cu is not expected to be sufficiently corrosion resistant. Therefore a silver rich alloy with an alpha crystal structure less than 10% Cu atomic content and up to 20% Zn atomic content will be interesting in terms of conductivity, corrosion resistance and costs. On the Cu rich side (alpha CuZn with some silver), the addition of silver will increase the conductivity so that thinner thin films are required. Alpha brass however was shown to be not sufficiently corrosion resistant. A resistivity minimum is expected in the beta phase region, where (Cu+Ag )/(Cu+Ag+Zn) atomic content is in the range of 45-55%. Due to the high cost of silver, the improvement of the thin film conductivity needs to be sufficiently high.

Addition of gold (Au) to CuZn or AgZn is also possible but not preferred.

Sn alloying can be attractive for thin Cu-Zn or Ag-Zn thin films for back electrodes. The optimization of resistivity and selenization resistance is critical, as a poor resistivity will require thicker films and hence higher materials cost. It is expected that a small amount of tin will further reduce the selenization rate.

Also, as discussed above, both Sn (group IVa of the periodic table) and Ti (group IVb of the periodic table) prefer oxidation state 4 and form very stable IV-oxides SnO₂ and TiO₂. This is why other elements of group IVb (Zr, Hf) and of group IVa (Si, Ge) are expected to have a similar effect, i.e. zirconium (Zr) or hafnium (Hf) silicon (Si), germanium (Ge), as well as carbon(C) and lead(Pb).

For making a CuZnSn thin film, an attractive process would be the use of alpha brass (CuZn) and copper tin bronze target CuZnSn. These alloys are low cost metals which are easy to machine.

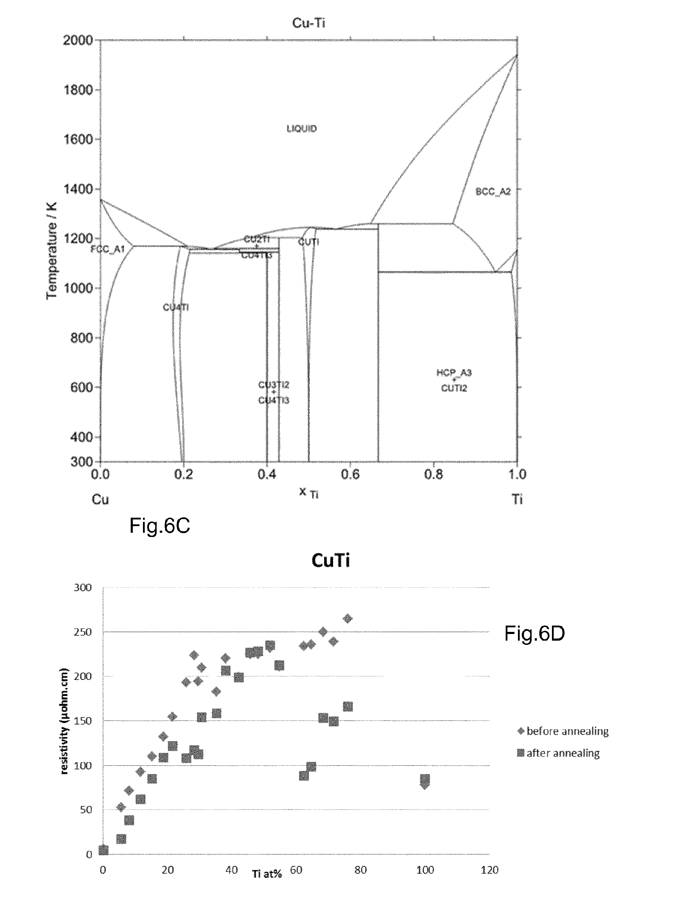

Fig.6C is a CuTi phase diagram, showing that CuTi alloys have higher melting points.

Fig.6D shows the measured resistivity of CuTi thin films vs. the atomic Ti content. 80nm of CuTi were deposited by magnetron sputtering at room temperature, by co-sputtering of a Cu target and a Ti target. The diamonds correspond to the measured resistivity before annealing and the squares to the measured resistivity after annealing at 550°C during 3 minutes.

It was found that the resistivity increases rapidly even with a small amount of Ti content.

For obtaining a resistivity below 20 µΩ.cm, an atomic content of Ti of at most 10% is preferred, more preferably at most 5%.

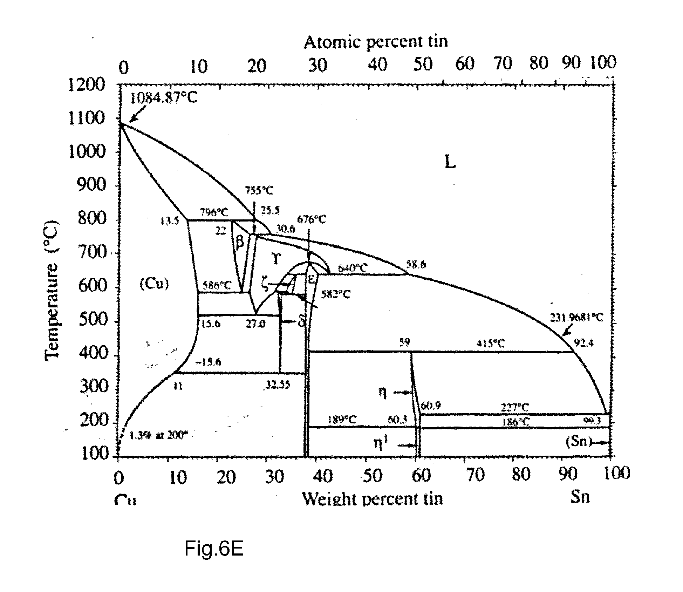

Fig.6E show the CuSn phase diagram. The atomic content of Sn is preferably of at most 30%, for the following reasons:
(1) the conductivity decreases with increasing Sn content (bulk Cu 59,1 • 10⁶ A/(V • m); bulk Cu90Sn10: 11*10⁶ A/(V • m), bulk Cu70Sn30 : 3*10⁶ A/(V • m));
(2) the melting point strongly decreases to about 700°C for 30% Sn as shown on Fig.6E. With increasing Sn content, however, hardness should increase, which can be advantageous for the patterning processes. In bulk metallurgy, Sn is often partly replaced by Zn. CuZnSn is also a suitable alloy. The optimum of corrosion resistance vs conductivity and melting point is yet to be determined. The optimum condition needs to be more on the Cu rich side than in the CuZn system, where an optimum between corrosion resistance and conductivity was found for the CuZn beta phase for a Zn atomic content of close to 50%.

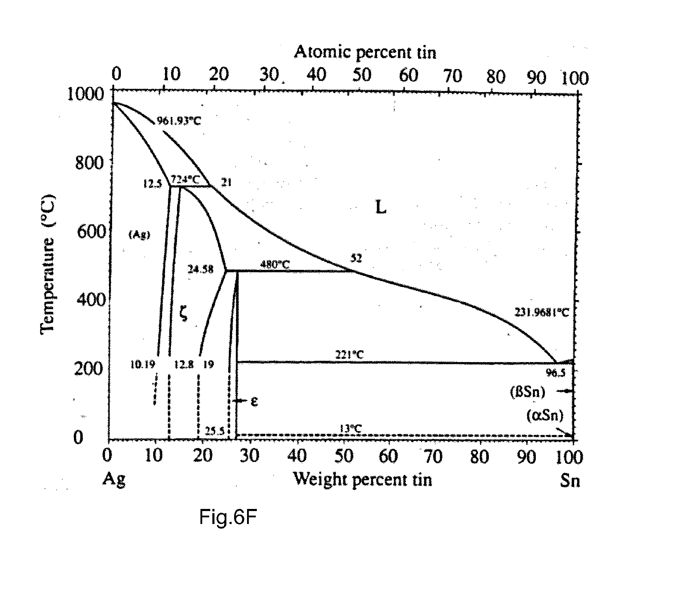

Fig.6F is an AgSn phase diagram. The melting point decreases strongly with Sn content. The Sn atomic content should be limited to at most 20%, and preferably to at most 10%. The conductivity in the Ag rich region is high. The alloying with Sn is reported to decrease the tendency of Ag to tarnish, which is a reaction of Ag with small quantities of hydrogen sulfide in ordinary atmospheric conditions. This property is interesting for the application of AgSn to thin film solar cells. By alloying Cu or Ag with Sn, the corrosion resistance of the alloy is expected to increase by binding the Cu into CuSn phases that are more chemically stable in the presence of sulphur or selenium, than Cu itself.

In a general manner, the alloy thin film 8 is thus based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

In other words also, the alloy thin film 8 is based on at least two elements, at least one first element M_{A} chosen among group (Ib) of the periodic table, and at least one second element M_{B} chosen among zinc (Zn), group (IVa) and group (IVb) of the periodic table.

Also, it may further contain minority elements. It may thus contain one or more of the following additional elements: titanium, (Ti), aluminum (Al), molybdenum (Mo), manganese (Mn), vanadium (V), silicon (Si) and arsenic (As), antimony (Sb) with a total maximum atomic content of at most 5% (i.e. taken together), preferably of at most 2%. These metals are for example additives for increasing the hardness or by-products of the metallurgical processes (mining, refining, target manufacturing).

Preferably, in all previous embodiments, the alloy thin film 8 also has an oxygen (O) and nitrogen (N) total maximum atomic content below 5% (i.e. taken together), preferably below 2%.

### Barrier to selenization

The barrier to selenization thin film 10 further protects the alloy thin film 8 from possible selenization and/or sulphurization. It should be noted that a thin film which protects from selenization also protects from sulphurization.

The term "barrier thin film to selenization" is understood to mean a thin film of a material of any type capable of preventing or reducing the selenization of thin films covered with the barrier to selenization during the deposition, on the barrier to selenization, of thin films of semiconducting materials formed by selenization and/or sulphurization. The barrier to selenization within the meaning of the invention shows a proven effectiveness even at a thickness of 3 nm.

A selenization possible test for determining if a material is suitable or not for a role as barrier to selenization is to compare a sample with and without a thin film of 5 nm of this material between the ohmic contact thin film 12 and the alloy thin film 8 and to subject the samples to a selenization, for example by heating at 520°C in a 100% selenium atmosphere at atmospheric pressure during 10 minutes. If the selenization of the alloy thin film 8 is reduced or prevented and the ohmic contact thin film 12 is entirely selenized, the material is effective.

The material of the barrier to selenization thin film 10 is, for example, based on a metal nitride or oxynitride M'ON such as TiOₓN_{y}, MoOₓN_{y}, WOₓN_{y}, NbOₓN_{y}, ReOₓN_{y}, ZrOₓN_{y}, TaOₓN_{y}, AlOₓN_{y} or of a metal oxide such as MoOₓ or TiOₓ.

Generally, it is a material of any type suitable for protecting the alloy thin film 8 from a possible selenization or sulphurization.

The material can also be based on a metal oxide, such as molybdenum oxide, titanium oxide or a mixed oxide of molybdenum and titanium.

However, the oxynitrides are preferred to the oxides.

More preferably, it concerns a material based on at least one among MoₓO_{y}N_{z}, WₓO_{y}N_{z}, TaₓO_{y}N_{z}, NbₓO_{y}N_{z}, ReₓO_{y}N_{z},even more preferably MoₓO_{y}N_{z}.

The barrier to selenization thin film has preferably a compressive stress between 0 and -10GPa, preferably between -1 and -5 GPa.

The barrier to selenization thin film is also preferably nano-crystalline or amorphous with a grain size of at most 10nm.

Alternatively, nitrides could also be used for all of the above listed materials, i.e. x=0. MoN was most often used in the experiments.

It may also be based on several metal oxynitrides MON, M'ON, etc.
or several nitrides.

It should be noted that the above nitrides, oxides and oxynitrides can be substoichiometric, stoichiometric or superstoichiometric respectively in nitrogen and oxygen.

Preferably though, in the case of oxynitrides, the barrier to selenization thin film has a molar composition O/(O+N) of at least 1 % and at most 50%.

Preferably also, the barrier to selenization thin film has a molar composition M'/(M'+O+N) of at least 15% and at most 80%.

Back contact substrate (1) according to any one of claims 31 to 35, wherein the barrier to selenization thin film has a thickness of at least 5 nm and at most 100nm, preferably at least 10nm and at most 60nm.

The barrier to selenization 10 has, for example, a thickness of less than or equal to 100 nm, preferably of less than or equal to 60 nm, more preferably of less than or equal to 40 nm.

If the barrier to selenization 10 is very thin, there is a risk of it no longer having a significant effect. It thus has, for example, a thickness of at least 5 nm, preferably of at least 10 nm. The barrier to selenization 10 has a lower conductivity than the alloy thin film 8. For example, it has a resistivity of between 200 µohm.cm and 1000 µohm.cm, in the case of a thin film based on a metal oxide, nitride or oxynitride.

As a result of the slight thickness of the barrier to selenization 10, a high resistivity is not harmful to the performance of the cell, the electrical current passing transversely.

The barrier to selenization 10 is, in addition, preferably capable of limiting the backward diffusion of the sodium ions towards the carrier substrate 2, that is to say the diffusion of the sodium ions from the top of the ohmic contact thin film 12 through the ohmic contact thin film 12 and towards the carrier substrate 2.

This property is advantageous in several respects.

It renders more reliable the manufacturing processes consisting in adding alkali metals in order to form the photoactive material, for example by deposition of a sodium compound on the ohmic contact thin film 12 of the electrode 6 or by addition of a sodium compound during the deposition of the photoactive material, for example using targets comprising sodium or other alkali metals, as described in US-B-5 626 688.

Fig.7 depicts the results of another experiment illustrating the efficiency of a MoN selenization barrier thin film for different thicknesses:

200nm thick metal thin films were deposited on soda-lime-silica glass substrates (5×10cm²) with a Si₃N₄ alkali barrier (140nm); the metal thin films were covered with MoN barrier thin films with different thicknesses. The mass was determined before and after the selenization test. The result was that for thinner barriers all metal films showed a similar weight gain. At 50nm MoN, the overall mass gain is reduced, but without differences between Cu and CuZn. For a barrier thickness of 80nm, Cu70Zn30 and Cu50Zn50 showed a much smaller weight gain.

Using a Cu45Zn55 CuZn alloy target thin films with good resistance of 1-1.2 Ω/□ could be deposited by sputtering. The selenization test was performed with 80nm MoN selenization barrier and 40nm Mo. The mass gain was low (4-6mg/100cm²) and the resistance dropped to 0.6-0.8 Ω/□.

Surprisingly, the barrier to selenization was thus proved more satisfactory total with an alloy based on Zn and copper.

### Ohmic contact thin film

The metal M used for the ohmic contact thin film 12, is capable of forming, after sulphurization and/or selenization, an ohmic contact thin film with a photoactive semiconducting material, in particular with a photoactive semiconducting material based on copper and selenium and/or sulphur chalcopyrite, for example a photoactive material of Cu(In,Ga)(S,Se)₂ type, in particular CIS or CIGS, CIGSSe, or also a material of Cu₂(Zn,Sn)(S,Se)₄ type or a material of cadmium telluride (CdTe) or cadmium sulphide (CdS) types.

The term "an ohmic contact thin film" is understood to mean a thin film of a material such that the current/voltage characteristic of the contact is non-rectifying and linear.

Preferably, the ohmic contact thin film 12 is the final ohmic contact thin film of the electrode 6, that is to say that the electrode 6 does not have another thin film above the thin film 12.

The thin film 12 is intended to be fully transformed, by selenization and/or sulphurization, into Mo(S,Se)₂, which material is not, on the other hand, regarded as a material "based on elemental molybedenum" but a material based on molybdenum disulphide, on molybdenum diselenide or on a mixture of molybdenum disulphide and diselenide.

Conventionally, the notation (S,Se) indicates that this concerns a combination of SₓSe₁₋ₓ with 0 ≤ x ≤ 1.

It should be noted that the substrate illustrated in Figure 1 and described above is an intermediate product in the manufacture of a photovoltaic cell or module. This intermediate product is subsequently transformed as a result of the process for the manufacture of the photoactive material. The back contact substrate 1 described above is understood as the intermediate product before transformation, which can be stored and dispatched to other production sites for the manufacture of the module.

The ohmic contact thin film 12, so as to act as ohmic contact once transformed into Mo(S,Se)₂, for example has a thickness of at least 10 nm and at most 100 nm before selenization, preferably of at least 30 nm and at most 50 nm. A large thickness is not necessary. After selenization, Mo(S,Se)₂ has a thickness which is 3-4 times the thickness of the initial molybdenum thin film.

The said metal M is advantageously molybdenum-based and/or tungsten-based.

The molybdenum disulphide and/or diselenide compounds Mo(S,Se)₂ are materials having a proven effectiveness as ohmic contact thin film. Tungsten (W) is a material with similar chemical properties. It also forms chalcogenide semiconductors WS₂ and WSe₂. Mo(S,Se)₂ and W(S,Se)₂ can both be formed as p type semiconductors. More generally still, it concerns a metal M of any type capable of forming, after sulphurization and/or selenization, an ohmic contact thin film with a photoactive semiconducting material, more particularly with a photoactive material based on copper and selenium and/or sulphur chalcopyrite.

### Interlayer

The possible interlayer thin films between the alloy thin film 8 and the barrier to selenization thin film 10 will now be described.

The interlayer thin film is preferably metallic and based on at least one of the refractory elements titanium (Ti), tungsten (W), molybdenum (Mo), rhenium (Re), niobium (Nb) or tantalum (Ta). Concerning titanium (Ti), it should be noted that if the titanium (Ti) thin film is thick or the process at a relatively low temperature, titanium is not totally consumed in the alloy and there might remain a residual thickness of titanium. These metals have very high melting points. They are corrosion resistant and can further increase the protection of the alloy thin film against sulfur and selenium. In addition, these metals show a very high hardness. Both physical properties are advantageous for the patterning and cell definition processes that are typically used for the manufacturing of thin film solar modules. In these processes, some thin films of the solar cell may have to be selectively removed without damaging the other thin films: in P1 scribing, the back electrode made of the alloy thin film and optional barrier to selenization thin film and ohmic contact thin film need to be cut without destroying the alkali barrier thin film, in P2 scribing, the absorber thin film needs to be cut without damaging the back electrode and in P3 scribing, the transparent conducting oxide needs with or without the absorber thin film to be cut without damage to the back electrode stack. These selective thin film removal processes can be made by laser processes (P1,P2,P3) or mechanical processes (P2,P3). In both cases the interlayer thin film will protect the conducting alloy thin film 8 due to its hardness and high melting point.

### Carrier substrate

The carrier substrate 2 and the barrier to alkali 4 will now be described. The carrier substrate can be rigid or flexible and can be made of a variety of materials such as soda-lime-silica or borosilicate glass, ceramic sheets, metal films, or polymer films.

Two cases may be distinguished: the case where alkali are added on the back contact substrate during or before the formation of the absorber thin film (first case) and the case where only migration of alkali from the carrier substrate is used for doping the absorber layer (second case).

The substrates provided with one or more barrier to alkali thin films 4 (i.e. a barrier to the diffusion of alkalispecies) are used in the first case, in particular in order to make it possible to use, as substrate, a sheet of glass of soda-lime-silica type obtained by the float process, glass of relatively low cost which exhibits all the qualities which are known in this type of material, such as, for example, its transparency, its impermeability to water and its hardness.

The content of alkali species of the substrate 2 is, in this case, a disadvantage which the barrier to alkali thin film 4 will minimize, since only alkali from the addition on the back contact substrate and in a controlled amount are wanted.

The barrier to alkali 4 is preferably based on at least one of the materials chosen from: silicon nitride, silicon oxide, silicon oxynitride, silicon oxycarbide, a mix of silicon oxycarbide and silicon oxynitride, aluminum oxide or aluminum oxynitride.

Alternatively, a soda-lime-silica glass substrate is used without a barrier to alkali thin film but the alkali mobility is reduced by a matrix adaptation to benefit of the so-called mixed-alkali effect. The sodium content that may diffuse through the electrode to dope the photoactive material is significantly reduced and alkali are added during or before formation of the absorber thin film.

In an alternative form, still in the first case, the carrier substrate 2 is a sheet of a material of any appropriate type not comprising alkali species, for example a silica-based glass not comprising alkali species such as borosilicate glasses, high-strain point glass or made of plastic, or even of metal.

In the second case (no addition of alkali), the carrier substrate 2 is of any appropriate type comprising alkali species, for example comprising sodium ions and potassium ions.

The substrate is, for example, a soda-lime-silica glass. The barrier to alkali thin film is absent.

In both cases, the carrier substrate 2 is intended to act as back contact in the photovoltaic module once the electrode is formed on it and thus does not need to be transparent. The sheet constituting the carrier substrate 2 can be flat or rounded, and can exhibit dimensions of any type, in particular at least one dimension of greater than 1 meter.

### Manufacturing Process

Another subject-matter of the invention is a process for the manufacture of the back contact substrate 1 described above.

The process comprises the stages consisting in:
- depositing the alloy thin film 8 on the carrier substrate 2, with optional prior deposition of the barrier to alkali thin film 4 and /or optional prior deposition of the adhesion thin film;
- depositing the optional barrier to selenization thin film 10 on the alloy thin film 8, for example directly on it or with interposition of an intermediate thin film;
- depositing the optional ohmic contact thin film 12 based on the metal M on the barrier to selenization thin film 10, in which case transforming the said thin film based on metal M into a sulphide and/or selenide of the metal M. This transformation stage can be a separate stage before the formation of the CIS, CIGS or CZTS semiconducting thin film or a stage carried out during the selenization and/or sulphurization of the CIS, CGS or CZTS semiconducting thin film, whether this selenization and/or sulphurization is carried out during the deposition of the said semiconducting thin film or after deposition of metal components said to be precursors of the semiconducting thin film.

In the course of the industrialization of the sputtering process of CuZn-thin films or AgZn or AgCuZn, the deposition of multilayer elemental stacks instead of alloyed thin films is a possible alternative. Especially in this case, deviations from the targeted alloy phase should be expected for the alloy thin film. An extreme case would be a multilayer stack of elemental Cu and elemental Zn or a multilayer stack of elemental silver and zinc or alternating thin films of elemental Cu, elemental silver and elemental zinc.. After thermal processing of the CIGSSe thin film on this substrate, the phase transformation into more desirable CuZn or AgZn or CuAgZn phases is achieved. This circumstance, however, has significant impact on production monitoring and process control.

Typically, in a magnetron sputtering deposition chamber, several thin films of one and the same material will be successively formed on the carrier substrate by several targets in order to form, after thermal annealing, just one thin film of one and the same material.

For example, in the case of CuZn
- successive metal thin films Cu/Zn or Zn/Cu
- 1 metal thin film/1 alloy rich in Zn thin film: Cu/CuZn_{rich}/Cu
- 1 metal thin film/1 alloy poor in Znthin film: Zn/CuZpₒₒᵣ/Zn
- 2 alloys CuZn_{richthin film}/CuZnₚₒₒᵣthin film or CuZnₚₒₒᵣ/CuZn_{rich}
   or any combination thereof. This example can be transposed to any alloy mentioned here above.

This is why according to an embodiment of the invention, the process of forming the alloy thin film comprises the steps of;
- forming a thin film containing at least one of the first element(s) M_{A}; and
- forming another thin film of a different material and containing at least one of the second element(s) M_{B}.

The deposition of the various thin films is, for example, carried out by magnetron cathode sputtering but, in an alternative form, another process of any appropriate type is used, e.g. thermal evaporation, chemical vapor deposition or electrochemical deposition.

### Photovoltaic Cell

Another subject-matter of the invention is a semiconductor device 20 (Figure 6) which uses the back contact substrate 1 described above to form one or more photoactive thin films 22, 24 thereon.

The first photoactive thin film 22 is typically a doped thin film of p type, for example based on copper Cu, indium In, and selenium Se and/or sulphur S chalcopyrite. It can be, for example, as explained above, CIS, CIGS, CIGSSe or CZTS.

The second photoactive thin film 24 is doped, of n type and described as buffer. It is, for example, composed of CdS (cadmium sulphide) and is formed directly on the first photoactive thin film 22.

In an alternative form, the buffer thin film 24 is, for example, based on InₓS_{y}, Zn(O,S) or ZnMgO or is made of another material of any appropriate type. In an alternative form again, the cell does not comprise a buffer thin film and the first photoactive thin film 22 itself forms a p-n homojunction.

Generally, the first photoactive thin film 22 is a thin film of p type or having a p-n homojunction obtained by addition of alkali metal elements.

The deposition of the photoactive thin film comprises stages of selenization and/or sulphurization, as explained in more detail below. The deposition can be carried out by evaporation of the elements Cu, In, Ga and Se (or Cu, Sn, Zn, S). During these selenization and/or sulphurization stages, the ohmic contact thin film 12 based on the metal M is transformed into a thin film 12' based on M(S,Se)₂. This transformation concerns, for example, the whole of the ohmic contact thin film 12.

The semiconducting device 20 thus comprises:
- the carrier substrate 2 and the electrode 6' formed on the carrier substrate 2, the ohmic contact thin film 12' of which has been transformed.

The electrode 6' comprises:
- the alloy thin film 8;
- the optional barrier to selenization thin film 10 formed on the alloy thin film 8; and
- the optional ohmic contact thin film 12', based on M(S,Se)₂, formed on the barrier to selenization 10. The semiconducting device comprises, on the ohmic contact thin film 12' and in contact with the latter, the photoactive semiconducting thin film(s) 14, 16.

Another subject-matter of the invention is a photovoltaic cell 30 comprising a semiconducting device 20 as described above.

The cell comprises, for example, as illustrated in Figure 6:
- the semiconducting device 20 formed by the thin films 8, 10, 12', 22 and 24;
- a transparent electrode 32, for example made of ZnO:Al, formed on the first photoactive thin film 22 and on the buffer thin film 24, in the event of the presence of the latter, with optional interposition, between the transparent electrode 32 and the semiconducting device 20, of a resistive thin film 34, for example of intrinsic ZnO or of intrinsic ZnMgO.

The transparent electrode 32 comprises, in an alternative form, a thin film of zinc oxide doped with gallium or boron, or also an indium tin oxide (ITO) thin film.

Generally, it is a transparent conducting material (TCO) of any appropriate type.

The transparent electrode 32 is the so-called front electrode. As a reminder, in a photovoltaic cell or module, the back electrode 6 is the electrode placed after the absorber thin film on the path of incoming light and the front electrode the one placed before. This is why a carrier substrate 2 with a back electrode 6 deposited on it is called a back contact substrate.

For a good electrical connection and good conductance, a metal grid (not represented) is subsequently optionally deposited on the transparent electrode 32, for example through a mask, for example by an electron beam. It is, for example, an Al (aluminum) grid, for example with a thickness of approximately 2 µm, on which is deposited a Ni (nickel) grid, for example with a thickness of approximately 50 nm, in order to protect the Al thin film.

The cell 30 is subsequently protected from external attacks. It comprises, for example, to this end, a counter-substrate 40covering the front electrode 32 and laminated to the coated substrate, i.e. to the front electrode 32, via a lamination foil 50 made of a thermoplastic polymer. It is, for example, a sheet of EVA, PU or PVB.

Another subject-matter of the invention is a photovoltaic module comprising several photovoltaic cells formed on the same substrate 2, which cells are connected to one another in series and are obtained by subsequent patterning and coating of the thin films of the semiconducting device 20. This monolithic integration of up to 100 individual cells is the state of the art for large area commercial thin film modules. It also includes the making of one to more than 100 laser P1 scribing trenches through the ohmic contact thin film 12, the barrier to selenization thin film 10 and the alloy thin film 8.

Another subject-matter of the invention is a process for the manufacture of the semiconducting device 20 and of the photovoltaic cell 30 above, which process comprises a stage of formation of a photoactive thin film by selenization and/or sulphurization.

Numerous known processes exist for the manufacture of a photoactive thin film of Cu(In,Ga)(S,Se)₂ type. The photoactive thin film 22 is, for example, a CIGS or CIGSSe thin film formed in the following way.

In a first stage, the precursors of the thin film are deposited on the electrode 6.

A metal stack composed of an alternation of thin films of CuGa and In type is, for example, deposited on the electrode 6 by magnetron cathode sputtering at ambient temperature. A thin film of selenium is subsequently deposited at ambient temperature directly on the metal stack, for example by thermal evaporation.

In an alternative form, the metal stack has, for example, a multilayer structure of Cu/In/Ga/Cu/In/Ga... type.

In a second stage, the substrate is subjected to a heating treatment at high temperature, referred to as RTP ("Rapid Thermal Process"), for example at approximately 520°C, in an atmosphere composed, for example, of gaseous sulphur, for example based on S or H₂S, thus forming a thin film of CuInₓGa₁₋ₓ(S,Se)₂.

One advantage of this process is that it does not require an external source of selenium vapour. The loss of a portion of the selenium during the heating is compensated for by an excess deposition of selenium on the metal stack. The selenium necessary for the selenization is provided by the deposited thin film of selenium.

In an alternative form, the selenization is obtained without the deposition of a thin film of selenium but by an atmosphere comprising gaseous selenium, for example based on Se or H₂Se, prior to the exposure to an atmosphere rich in sulphur.

As explained above, it can be advantageous to deposit a thin film based on alkali species, for example on sodium, for exact dosing of the sodium in the photoactive thin film.

Prior to the deposition of the CuGa and In metal stack, the alkali species are, for example, introduced by the deposition, on the sacrificial molybdenum-based thin film 12, of a thin film of sodium selenide or of a compound comprising sodium, so as to introduce, for example, of the order of 2 × 10¹⁵ sodium atoms per cm². The metal stack is deposited directly on this thin film of sodium selenide.

It should be noted that there exist numerous possible alternative forms for forming the CI(G)S or CZTS thin films, which alternative forms include, for example, the co-evaporation of the above mentioned elements, chemical vapour deposition, electrochemical deposition of metals, selenides or chalcopyrites, reactive sputtering of metals or selenides in the presence of H₂Se or H₂S.

Generally, the process for the manufacture of the photoactive thin film 22 is of any appropriate type.

All the processes for the manufacture of thin films of CIS or CZTS type use a stage of heating at high temperature in the presence of selenium and/or of sulphur in the vapour state or in the liquid state.

An important aspect of this invention is that the electrode can reach its final properties, like phase composition and resistivity, during the high temperature steps of solar cell process. Particularly the resistivity may drop advantageously to improve the solar cell efficiency.

### FURTHER RESULTS AND EXPERIMENTS

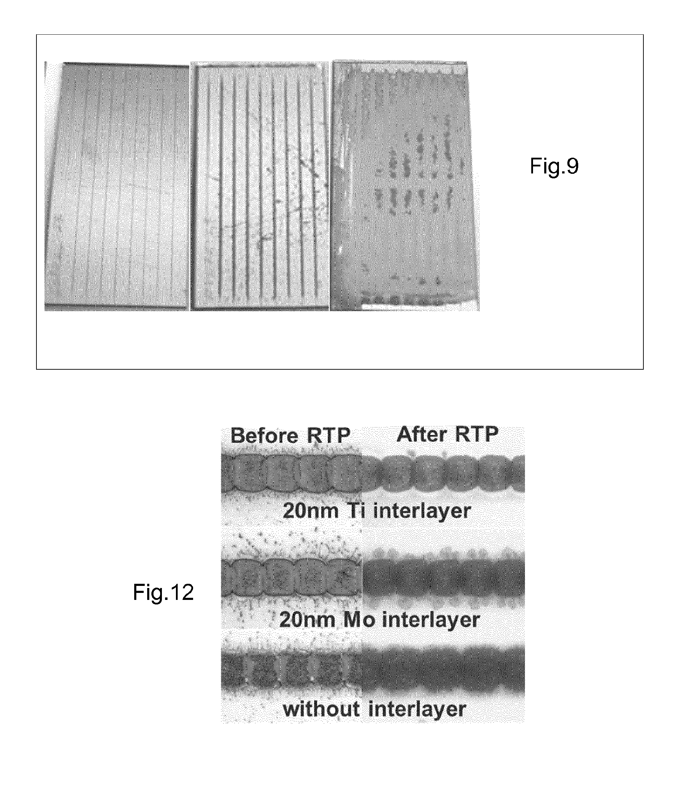

As shown on Fig.9, different back electrode stacks were directly compared in a corrosion test under Se-containing ambient at high temperature.

The different P1 patterned back electrodes were made of the following stacks:
Glass carrier substrate/ Si₃N₄-90nm/Ti-2nm/CuZn-100nm/Interlayer-20nm/MoN-80nm/Mo-45nm.

The sample shown on the left have a titanium interlayer of 20nm, the sample in the middle a molybdenum interlayer of 20nm, and the one on the right had no interlayer between CuZn and MoN, that is to say, the following stacks:
Left:
   Glass/ Si₃N₄-90nm/Ti-2nm/CuZn-100nm/Ti-20nm/MoN-80nm/Mo-45nm Middle:
   Glass/ Si₃N₄-90nm/Ti-2nm/CuZn-100nm/Mo-20nm/MoN-80nm/Mo-45nm
Right:
   Glass/ Si₃N₄-90nm/Ti-2nm/CuZn-100nm/MoN-80nm/Mo-45nm

The sample including a significant Ti layer thickness in the stack before the annealing showed a clear benefit in resisting against the chemically aggressive Se corrosion conditions. The lateral corrosion as visible from corrosion fronts around laser scribed lines of the back electrode and around defect points in the barrier layer is significantly reduced in case of a significant Ti content.

### Results:

**Table III**

| Sample | Ti-20nm | Mo-20nm | no interlayer |
|---|---|---|---|
| Resistance in Ω/□ | 1.45 | 1.15 | 25 |
| Mass gain | 4.5mg/50cm² | 5.2mg/50cm² | 8.1 mg/50cm² |

The photographs were taken through the back electrode substrate after a Se-corrosion test as described above for testing the barrier to selenization thin film. The stack condition including a 20nm Ti interlayer visually shows the least corrosion attack over the electrode area as well as around the laser scribes (vertical lines). Also, the Se mass gain during the test, which is a measure of the amount of Se reacting with the layer components, is lowest for this condition. Obviously, the presence of a significant amount of Ti helps to reduce the corrosion. In this stack, the 20nm Ti layer corresponds to a Ti content of about 10 at% within the CuZnTi layer.

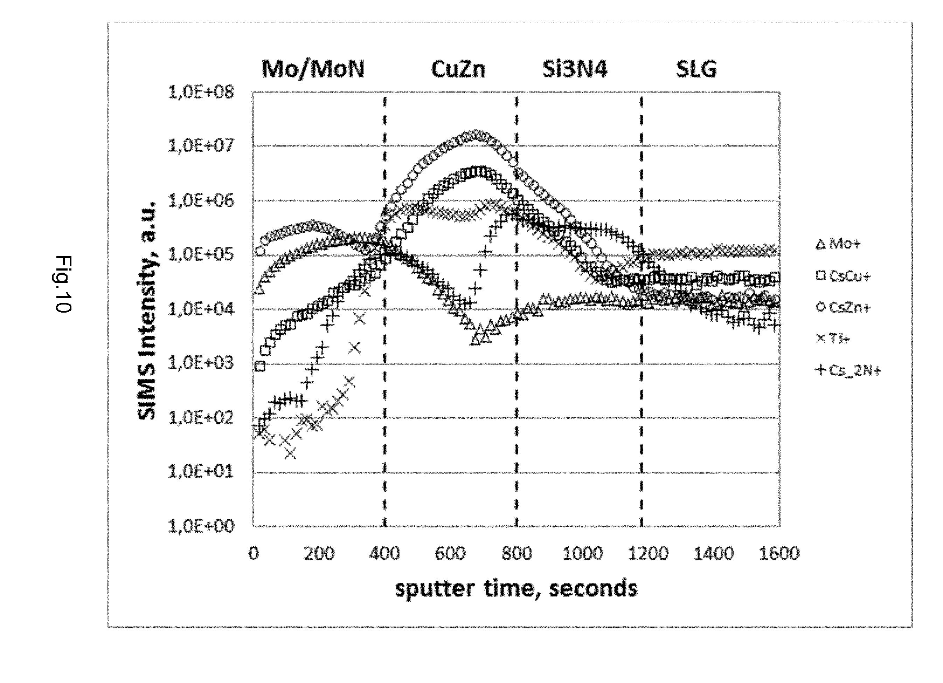

Also, it should be noted that several observations confirm that a CuZnTi alloy was formed from a CuZn/Ti layer stack during thermal annealing, during the Se-test and during the solar cell process.
(1) a significant change in color is observable through the substrate glass during the various thermal processes. The same is observed for annealing of the back electrode stack as well as during RTP (i.e. solar cell process). This color change is not present if no Ti interlayer is contained in the stack.
(2) Adding an interlayer of Ti leads to a slight increase in resistivity as compared to pure CuZn layer stacks without Ti or with a Mo interlayer. To this end, an optimum in the total Ti amount with respect to the CuZn needs to be defined as a compromise between a low electrical resistivity and being sufficiently corrosion resistant at the same time.
(3) SIMS Analysis (Secondary Ion Mass Spectroscopy) clearly shows (Fig.10) that after annealing a stack glass/Si₃N₄-90nm/Ti-2nm/CuZn-100nm/Ti-20nm/MoN-40nm/Mo-45nm, the Ti had completely diffused into the CuZn layer with some remaining accumulation at the interface to MoN and to Si₃N₄.

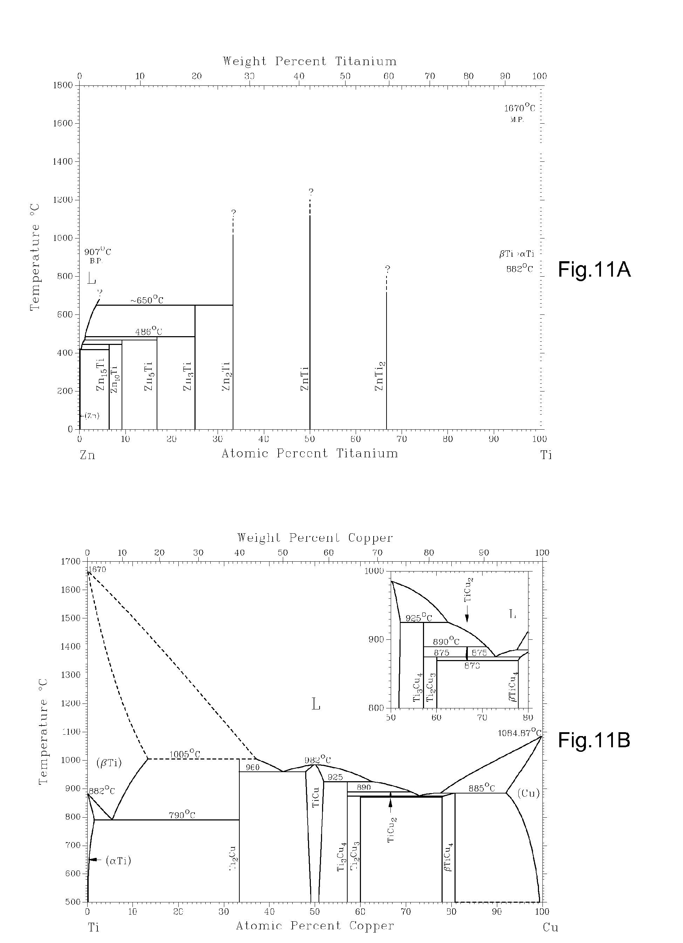

Assessing from the CuTi and ZnTi phase diagrams (Fig.11A and 11B), a Ti content in CuZn below 10% is a reasonable choice. (also for resistivity aspect see graph above) The existence of the stable intermetallic phases Zn15Ti and Zn10Ti suggests that Ti can stabilize the Zn distribution in these compounds and thus prevent dezincification of the CuZn layer. Surplus Ti can be buffered in the Cu alpha phase which itself can contain several at% Ti. The ternary CuZnTi phase diagram, however, is not accessible.

Microscopically, the lateral corrosion of the back contact during RTP showed significant differences. Fig.12 shows optical micrographs as seen through the glass of P1 patterned stacks before and after RTP for the following stacks (from images above to below):
glass/ Si₃N₄-90nm/Ti-2nm/CuZn-100nm/Ti-20nm/MoN-80nm/Mo-45nm
glass/ Si₃N₄-90nm/Ti-2nm/CuZn-100nm/Mo-20nm/MoN-80nm/Mo-45nm
glass/ Si₃N₄-90nm/Ti-2nm/CuZn-100nm/MoN-80nm/Mo-45nm

In Fig.12, the regular shape of the individual laser spots is only preserved for the stack including the 20nm Ti interlayer. If a 20nm Mo interlayer is applied, the lateral corrosion is severely enhanced showing dendritic structures. Without any interlayer (bottom image), the lateral corrosion leads to an irregular outline of the pattern and a significant corrosion front is observed perpendicular to the pattern.

The benefit of the additional Ti layer shown above is also apparent from the solar cell and module efficiency. In the table below, different results are listed, which show that the addition of a Ti interlayer increases the efficiency of CIGSSe cells and modules significantly on back electrode stacks containing a CuZn base layer:

**Table IV**

| **Back electrode stack** | Best Cell efficiency | 10×10cm² Best circuit efficiency | 10×10cm² Best module efficiency | 1.05m² Best Module Pmpp [W] |
|---|---|---|---|---|
| **glass/Si₃N₄/Ti/CuZn/Ti-20nm/MoN/Mo** | 14.3% | 13.5% | 12.8% | 123 |
| **glass/Si₃N₄/Ti/CuZn/Mo-20nm/MoN/Mo** | 13.5% | 12.4% | 10.7% | 115 |

It has to be noticed that all stack candidates in this table contain a thin (2nm) Ti adhesion layer between the CuZn-layer and the Si₃N₄ barrier. Although this layer was also found to alloy with the CuZn-layer, the absolute Ti content of the adhesion layer alone was too small to evoke the full beneficial effect of Ti addition.

Fig.13 shows the results of using the back contact substrate for making a CIGS or CIGSSe thin film.

Cu(In,Ga)(S,Se)2 thin films (CIGGSe) and solar cells with 1600nm CIGSSe absorbers, 30nm CdS buffer thin film and 1200nm ZnO:Al front electrode were processed on Cu50Zn50/MoN/Mo back electrode with a thickness of 100nm CuZn, 80nm MoN and 30nm of top Mo. In this case the CuZn thin film was deposited by sputtering alternatingly Cu and Zn thin films (about 50 passes using a rotating substrate holder).

The photographs show the backside of the 10x10 cm² substrate through the glass (top of Fig.13) and the front side of the CIGSSe film (bottom of Fig.13). No signs of corrosion or corrosion induced film peeling were observed. The numbers on the bottom right indicate the local values of the photoluminescence decay times (in ns). The values measured in a rectangular pattern across the substrate are comparable to a CIGSSe film on a conventional Molybdenum back electrode.

Also, solar cells with area of 1,4cm² were prepared by depositing a metal grid on top of the ZnO. Solar cell efficiency values of 13% were obtained without any optimization of the process. This discovery was particularly surprising as the solar cell manufacturing process involves several processing steps at temperatures between 100°C to 550°C. The high values of photoluminescence decay times and the good solar cell efficiency show that the alloy back electrode is stable and Cu and Zn do not diffuse into the CIGSSe absorber.

Solar cells with efficiency of 12% to 14% and solar modules of sizes between 100 cm² up to 1m² were also obtained by sputtering only one Cu thin film (50nm) and one Zn thin film (50nm) or by sputtering 2 or 4 double thin films. In these cases, the final phase composition forms during the solar cell process. The final alloy can also be formed by a pre-annealing at temperatures of 150°C. As the chalcogenide absorber formation processes usually require temperatures between 400° and 600°C, the alloy will form during the temperature ramp for the absorber formation process.

## Claims

1. Back contact substrate (1) for a photovoltaic cell comprising a carrier substrate (2) and an electrode (6), the electrode (6) comprising an alloy thin film based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

2. Back contact substrate (1) according to any preceding claim, wherein said alloy thin film has a total atomic content of the first(s) element(s) M_{A} and of the second(s) element(s) M_{B} of at least 90%, preferably at least 95%.

3. Back contact substrate (1) according to any preceding claim, wherein the first(s) element(s) M_{A} is/are chosen among copper (Cu) and silver (Ag).

4. Back contact substrate (1) according to any preceding claim, wherein the second(s) elements(s) M_{B} is/are chosen among zinc (Zn), titanium (Ti) and tin (Sn).

5. Back contact substrate (1) according to any one of claims 1 to 4, wherein the alloy thin film is based on silver (Ag) and zinc (Zn), said alloy thin film preferably having a relative atomic content of Zn/(Ag+Zn) of at most 75% , preferably at most 50%, even more preferably at most 30%.

6. Back contact substrate (1) according any one of claims 1 to 4, wherein is the alloy thin film is based on copper (Cu) and titanium (Ti), said alloy thin film preferably having a relative atomic content of Ti/(Cu+Ti) of at most 10%, more preferably at most 5%.

7. Back contact substrate (1) according to any one of claims 1 to 4, wherein the alloy thin film is based on copper (Cu) and tin (Sn), said alloy thin film preferably having a relative atomic content of Sn/(Cu+Sn) of at most 30%.

8. Back contact substrate (1) according to any one of claims 1 to 4, wherein the alloy thin film is based on silver (Ag) and tin (Sn), said alloy thin film preferably having a relative atomic content of Sn/(Ag+Sn) of at most 20%, preferably at most 10%.

9. Back contact substrate (1) according to any one of claims 1 to 4, wherein the alloy thin film is based on copper (Cu), zinc (Zn) and tin (Sn).

10. Back contact substrate (1) according to any one of claims 1 to 4, wherein the alloy thin film is based on copper (Cu), zinc (Zn) and titanium (Ti), said alloy thin film preferably having a relative atomic content of Zn/(Cu+Zn) of at least 20% and at most 60%.

11. Back contact substrate (1) according to any one of claims 1 to 4, wherein there the alloy thin film is based on copper (Cu), zinc (Zn) and titanium (Ti), said alloy thin film preferably having a relative atomic content of titanium (Ti)/(Cu+Zn+Ti) of at most 30% and at least 1%, preferably at most 20% and at least 5%.

12. Back contact substrate (1) for a photovoltaic cell comprising a carrier substrate (2) and an electrode (6), the electrode (6) comprising an electrically conductive coating comprising adjacent metallic thin films, at least one of the adjacent metallic thin films being based on at least a first element chosen among copper (Cu), silver (Ag) and gold (Au), and at least one of the adjacent metallic thin films being based on a at least a second element chosen among zinc (Zn), titanium (Ti), tin (Sn), silicon (Si), germanium (Ge), zirconium (Zr), hafnium (Hf), carbon (C) and lead (Pb).

13. Back contact substrate (1) according to claim 12, wherein after a thermal annealing treatment, the back contact substrate is according to any one of claims 1 to 11.

14. Photovoltaic cell (30) comprising a back contact substrate (2) according to any preceding claim and at least a thin film of a photoactive material.

15. Process for the manufacture of a back contact substrate (1) for a photovoltaic cell (30), comprising at least one step of making an alloy thin film based on at least two elements, at least one first element M_{A} chosen among copper (Cu), silver (Ag) and gold (Au), and a at least one second element M_{B} chosen zinc (Zn), titanium (Ti), tin (Sn), silicon (Si), germanium (Ge), zirconium (Zr), hafnium (Hf), carbon (C) and lead (Pb).
